## Europäisches Patentamt
## European Patent Office
## Office européen des brevets

(19)

(11) Veröffentlichungsnummer: **0 293 657 B1**

(12) **EUROPÄISCHE PATENTSCHRIFT**

(45) Veröffentlichungstag der Patentschrift: **04.09.91**

(51) Int. Cl.⁵: **H01L 39/24, H01L 39/12**

(21) Anmeldenummer: **88107698.8**

(22) Anmeldetag: **13.05.88**

(54) Verfahren zur Herstellung eines phasenreinen Hochtemperatur Supraleiters.

(30) Priorität: **21.05.87 DE 3717056**
**17.08.87 DE 3727381**

(43) Veröffentlichungstag der Anmeldung:
**07.12.88 Patentblatt 88/49**

(45) Bekanntmachung des Hinweises auf die
Patenterteilung:
**04.09.91 Patentblatt 91/36**

(84) Benannte Vertragsstaaten:
**CH DE FR GB IT LI NL**

(56) Entgegenhaltungen:
**GB-A- 1 529 966**

**WORLD PATENTS INDEX LATEST DATABA-
SE, accession no. 87-351454, Woche 50, 23.
Dezember 1987, Derwent Publications Ltd.,
London, GB; & JP - A - 62 253 740 (KABE
STEEL KK) 05.11.1987 (Kat. P,A)**

**JOURNAL OF CRYSTAL GROWTH, Band 85,
1987, Seiten 623-627, Amsterdam, NL; C.A.
COSTA "Synthesis of Yba2Cu3O7-x polycrystalline superconductors from Ba peroxide:
First physicochemical characterization"**

**PHYSICAL REVIEW LETTERS, Band 58, Nr. 9,**

**2. März 1987, Seiten 911-912, New York, US;
P.H. HOR et al.: "High-pressure study of the
new Y-Ba-Cu-O superconducting compound
system"**

**PHILIPS TECHNICAL REVIEW, Band 35, Nr.
2/3, 1975, Seiten 65-72, Eindhoven, NL; K.H.
HÄRDTL "A simplified method for the isostatic hot pressing of ceramics"**

(73) Patentinhaber: **Battelle-Institut e.V.
Am Römerhof 35 Postfach 900 160
W-6000 Frankfurt/Main 90(DE)**

(72) Erfinder: **Heide, Helmut, Dr.
Am Hohenstein 14
W-6233 Kelkheim(DE)**
Erfinder: **Winter, Heinrich, Dr.
Kurt-Schumacher-Strasse 4
W-6236 Eschborn(DE)**
Erfinder: **Hinze, Eckhard, Prof.Dr.
Jenaer Strasse 3
W-6301 Pohlheim 1(DE)**
Erfinder: **Poeschel, Eva, Dr.
Sodener Weg 51
W-6232 Bad Soden 3(DE)**

## Beschreibung

Die Erfindung betrifft ein Verfahren zur Herstellung eines weitgehend phasenreinen, oxidischen Hochtemperatur-Supraleiters der allgemeinen Zusammensetzung SE-EA-Cu-O, wobei SE seltene Erdmetalle und EA Erdalkalimetalle sind, durch Sintern einer Mischung der Ausgangsoxide zur Herstellung eines Supraleiters mit Perowskitstruktur,
insbesondere von $Y_1 Ba_2 Cu_3 O_{7-x}$, mit $x \leq 0,5$.

Seit den Ergebnissen der IBM-Arbeitsgruppe Bednorz, Müller über eine signifikante Erhöhung der Sprungtemperatur bei oxidischen Supraleitern hat weltweit eine intensive Forschungstätigkeit über diese Materialien eingesetzt. (Vgl. Bednorz, J.G.; Müller K.A.: Possible High $T_c$ Superconductivity in the Ba-La-Cu-O-System. Condensed Matter, Zeitschr. f. Physik 64, 189-193 (1986)). Seit Ende 1986 /Anfang 1987 wird über immer neue Erfolge auf diesem Gebiet berichtet. Das Interesse konzentriert sich hierbei auf Verbindungen mit den allgemeinen Formel

$$SE_1 EA_2 Cu_3 O_{7-x},$$

wobei für SE = seltene Erdmetalle und EA Erdalkalimetalle steht. Die oxidischen Supraleiter bestehen in der Überzahl aus Verbindungen dieser Stoffgruppe mit Perowskitstruktur. Die Supraleitfähigkeit und die hohen Sprungtemperaturen, die nach Politis und Mitarbeitern (Wu, M.K. et. al.: Superconductivity at 93° K in New Mixed Y-Ba-Cu-O Compound System at Ambient Pressure. Physical Review Letters 58, 908-910, 1987) durchaus 100° K überschreiten können, sind an bestimmte Perowskite mit unstöchiometrischen Sauerstoffgehalten gebunden. Sie hängen in einer heute noch nicht gänzlich geklärten Weise von dem Auftreten von $Cu^{3+}$ - $Cu^{2+}$ -Ladungszuständen im Perowskitgitter ab.

Bisher werden diese Verbindungen bei relativ hohen Sintertemperaturen aus entsprechenden homogenen Oxidgemischen gesintert, nachdem sie bei hohen Drücken kalt vorgepreßt wurden.

Man beobachtet nun, daß hierbei die entsprechenden Phasen - je nach Versuchsbedingungen - nur zu einem gewissen Anteil entstehen. Die Qualität, d.h. insbesondere die Sprungtemperatur $T_c$, hängt im wesentlichen von den Versuchsbedingungen ab.

Zur Zeit lassen sich hinsichtlich einer technischen Umsetzung folgende Probleme identifizieren:

- Die komplexe chemische Beschaffenheit, insbesondere die ungewöhnlichen Valenzzustände, sind technologisch schwer zu beherrschen. Die zur Gefügeverdichtung und Verbindungsbildung über Diffusionsreaktionen notwendigen relativ hohen Sintertemperaturen greifen systembedingt sowohl in die Sauerstoffgehalte als auch in die Valenzzustände und die Koordinationsverhältnisse der Perowskitstruktur ein.

- Die interessierenden supraleitenden Oxide bieten aufgrund ihrer Sprödigkeit große Probleme der Umformung, so daß neben der wissenschaftlichen Fragestellung in Zukunft auch die Umsetzung der wissenschaftlichen Erkenntnisse in die technische Anwendung supraleitender Werkstoffe Gegenstand der weltweiten Forschungsbemühungen ist.

Die bisher bekannt gewordenen Techniken zur Lösung der vorstehenden Probleme scheinen noch nicht geeignet, die komplexen surpaleitenden Werkstoffe in der notwendigen Qualität, Stabilität und Wirtschaftlichkeit entstehen zu lassen.

So ergibt eine kritische Durchsicht der Literatur, daß die physikalischen Phänomene der Supraleitfähigkeit zur Zeit noch von unkontrollierbaren Gefüge- und Struktureigenschaften abhängen. Insbesondere lassen sich die Einflüsse von Fremdphasen erkennen, die sich an den Korngrenzen der polykristallinen Werkstoffe anreichern. Hierdurch werden - je nach Konzentration und Verteilung der Fremdphasen - die Gesamteigenschaften des Materials entscheidend beeinflußt, obwohl diese schädlichen Korngrenzenbelegungen im Gesamtchemismus keine Rolle spielen müssen. Außerdem scheint die Gefügedichte Einfluß auf die Qualität der Supraleiter, d.h. insbesondere auf die Beständigkeit und die zulässige Stromdichte zu haben.

Die GB-A-1 529 966 beschreibt ein HIP-Verfahren für Pulvermaterialien, die in einem Glasbehälter mit innenliegender Schutzschicht, z.B. aus Quarz, hergestellt werden. Nach diesem Verfahren werden jedoch keine supraleitenden Materialien hergestellt und die vorzugsweise aus Quarz bestehende Schutzschicht übernimmt nicht die Funktion einer Eigensystembarriere in Bezug auf die zu kompaktierenden Pulvermaterialien. Quarz wird dort vielmehr offenbar verwendet, weil er chemisch träge ist.

Der Erfindung liegt daher die Aufgabe zugrunde, ein Verfahren vorzuschlagen, mit dem sich weitgehend oder vollständig phasenreine, oxidische Hochtemperatur-Supraleiter der angegebenen allgemeinen Formel herstellen lassen.

Zur Lösung dieser Aufgabe ist die Erfindung dadurch gekennzeichnet, daß das Sintern unter erhöhten Drücken durch Einschluß der Aus-gangsoxide in einem gasdichten Behälter in einem chemisch und physikalisch abgeschlossenen System erfolgt,

- daß der oxidischen Ausgangsmischung zur Erzeugung eines vorbestimmten Sauerstoffpartialdrucks wenigstens ein sich thermisch zersetzendes Metalloxid zugesetzt wird und

- daß die oxidische Ausgangsmischung zur thermodynamischen Stabilisierung der gewünschten Supraleiterphase mit einer Schutzschicht umhüllt wird, die in ihrer Zusammensetzung den jeweils koexistierenden Phasen des Supraleiters entspricht (thermodynamische Barriere).

Die Synthese der supraleitenden Stoffe erfolgt also in einem geschlossenen System, und zwar unter Druck (HIP oder Sprengkompaktieren).

Auch in dem oben beschriebenen geschlossenen System kann der notwendige Sauerstoffpartialdruck durch die Zugabe definierter Mengen instabiler Metalloxide eingestellt werden, die beim Erhitzen Sauerstoff abspalten und zweckmäßigerweise dem Stoffsystem entstammen, aus dem auch der Supraleiter selbst aufgebaut ist. Im vorliegenden Fall kann dies beispielsweise Bariumperoxid ($BaO_2$) sein. Neben dem normalerweise verwendeten Bariumoxid (BaO) wird das Peroxid in einer Menge zugegeben, wie es zur Einstellung des entsprechenden $O_2$-Partialdrucks notwendig ist.

Zur Erzielung eines abgeschlossenen Systems wird der Reaktionsraum in dem gasdichten Behälter (Metall- oder Glaskapsel) verschlossen. Diese für den HIP-Prozeß und das Sprengkompaktieren übliche Technik wird erfindungsgemäß zur Erzielung weitgehend phasenreiner Zustände wie folgt durchgeführt: Zur Vermeidung unerwünschter Reaktionen mit dem Kapselmaterial ist es vorteilhaft, eine Reaktionsbarriere aufzubauen. Im vorliegenden Fall besitzt dieses Barrieresystem eine doppelte Funktion: Vermeidung unerwünschter Reaktionen mit der Kapselwand und Vermeidung der Phasendifferenzierung an den Korngrenzen. Entscheidend ist es, als Barrierematerial eine Umhüllung mit solchen Verbindungen einzusetzen, die mit dem Supraleiter im Stoffsystem (z.B. Y-Ba-Cu-O) korrelieren.

Diese Eigensystembarriere bewirkt nun, daß der Supraleiterwerkstoff zum einen in einem arteigenen Material eingebettet ist. Zum anderen bewirkt diese Art der Barriere, daß die Ausbildung der korrespondierenden Phasen nicht im Werkstoff selbst an den Korngrenzen, sondern außen im Grenzbereich zum Barrierematerial erfolgt, wo sie unschädlich ist und später abgearbeitet werden kann. Auf diese Weise wird das gesamte System gepuffert und ist gegenüber stofflichen Inhomogenitäten unsensibel.

Sinngemäß läßt sich das vorstehend beschriebene Verfahren der Eigensystembarriere auf alle oxidischen (keramischen) Supraleiter anwenden. Die hier für das heißisostatische Pressen im gepufferten System angestellten Überlegungen gelten sinngemäß auch für das Sprengkompaktieren. Allerdings laufen hierbei die geschilderten Vorgänge bei sehr viel höheren Drücken im Mbar-Bereich und bei höheren Temperaturen sowie in sehr kurzen Zeiten ab. Während beim HIP-Prozeß phasenreine kristallisierte Zustände entstehen, sind die Phasen beim Sprengkompaktieren weniger gut ausgebildet. Andererseits eröffnet dieses Verfahren des Sprengkompaktieren nach vorherigem kaltisostatischen Vorpressen die Möglichkeit, von rasch erstarrten Pulvern der gewünschten Zusammensetzung auszugehen.

Die Synthese dichter Gefüge durch Drucksintern oder auch durch HIP ist an sich bekannt. Auch die Sprengkompaktierung dichter Gefüge wird insbesondere bei duktilen, kristallinen wie auch bei amorphen Werkstoffen eingesetzt. Die geschilderten generellen Probleme der Fremdphasenanreicherung an den Korngrenzen lassen sich aber durch diese Verfahren (HIP und Sprengkompaktieren) alleine nicht prinzipiell beseitigen. Im Falle der hier behandelten oxidischen Supraleiter zeigt es sich nämlich, daß es sehr schwierig ist, die gezielten Sauerstoffpartialdrücke zur Erreichung der entscheidend wichtigen Unstöchiometrie bei hohen Temperaturen einzustellen.

Das Sintern in abgeschlossenen Systemen unter hohem Gasdruck (HIP) hat nicht nur den Vorteil, daß sich dichte und porenfreie Gefüge herstellen lassen, sondern ein weiterer wesentlicher Aspekt ist die Möglichkeit, das System im kondensierten Zustand zu halten, wodurch die Bildung von Gasphasen unterdrückt wird und durch Einengung der Freiheitsgrade des Systems definierte Phasen entstehen können.

Insbesondere lassen sich durch das HIP-Verfahren und den Zusatz von definierten Mengen an Sauerstoff abspaltenden Oxiden, die nach Möglichkeit dem betreffenden Stoffsystem entstammen, z.B. Bariumperoxid, die notwendigen definierten Sauerstoffpartialdrücke innerhalb des gasdichten Behälters aufrechterhalten.

Ein weiterer interessanter Aspekt des HIP-Verfahrens mag darin bestehen, daß ganz allgemein die Temperaturbedingungen zur Synthese der ternären Verbindungen durch die gleichzeitige Anwendung von Druck und Temperatur erheblich niedriger sein können als beim Sintern unter Normaldruck. Dies konnte überzeugend demonstriert werden.

Die Erfindung wird im folgenden anhand eines Ausführungsbeispiels näher erläutert, aus dem sich weitere wichtige Merkmale ergeben.

Es zeigt:

Fig. 1    die Phasenbeziehung im ternären System $YO_{1,5}$- BaO-CuO und

Fig. 2    schematisch einen Schnitt durch eine Kapsel zur Durchführung des erfindungsgemäßen Verfahrens.

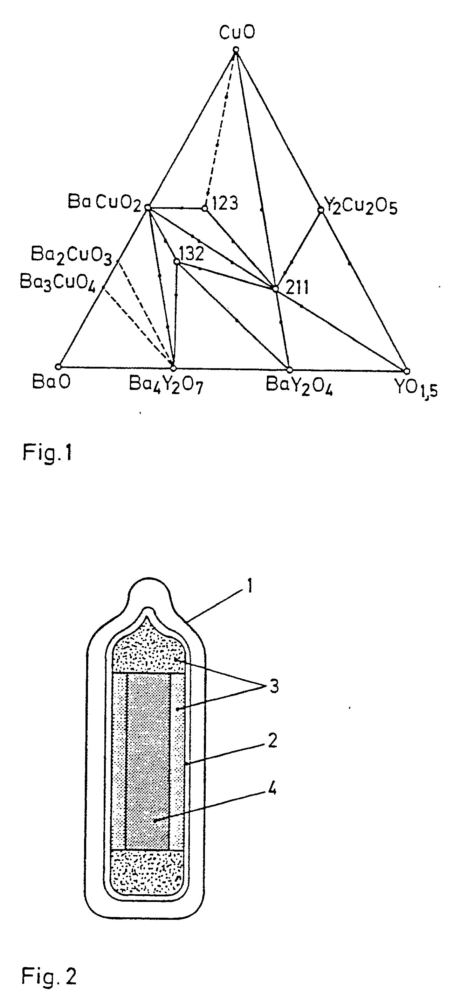

Fig. 1 zeigt die Phasenbeziehung im erwähnten ternären System nach Frase, K.G. et al.: Phase Compatibilities in the System $Y_2O_3$-BaO - CuO at 950°C. Submitted to Communications of the American Ceramix Society; April 7th, 1987.

In Fig. 2 ist eine Kapsel 1 dargestellt, die aus Glas oder Metall besteht. Sie ist innen mit einer ersten Barriere 2 ausgekleidet, die im wesentlichen zur chemischen Abschirmung gegen das Material der Kapsel dient. Innerhalb der ersten Barriere 2 befindet sich eine zweite Barriere 3, die als Puffer dient.

Innerhalb der zweiten Barriere 3 befindet sich nun ein den Supraleiter bildendes Ausgangsmaterial 4, vorzugsweise in einer Pulvermischung. Dieses Material 4 entspricht beispielsweise dem Punkt 123 im System nach Fig. 1.

Die zylindrische Probe 4 der gewünschten Zusammensetzung, z.B. 123, wird als hochverdichteter Pulverpreßling eingebettet in das mehrlagige Barrieresystem, welches zunächst die Aufgabe hat, unerwünschte Reaktionen der Probe mit dem Kapselmaterial (Glas oder Metall) zu verhindern. Hierzu bieten sich reaktionsträge Materialien an.

Die nächst der Probe 4 liegende Umhüllung 3 besteht aus den jeweils koexistierenden Phasen zur z.B. gewünschten Phase "123" in Fig. 1 ($Y_1Ba_2Cu_3O_{7-x}$) als thermodynamischer Puffer des Systems.

Die beim drucklosen Sintern beobachtete Bildung der koexistierenden Phasen im Gefüge wird durch diese Verfahrensführung in die Randphase des Supraleiters verlegt und kann später abgearbeitet werden.

Es ist somit ersichtlich, daß mit dem beschriebenen, erfindungsgemäßen Verfahren sich hochdichte, phasenreine oder zumindest weitgehend phasenreine Bulk-Materialien herstellen lassen, die beispielsweise aufgemahlen als Zwischenprodukte für die pulvermetallurgische Weiterverarbeitung dienen können.

**Patentansprüche**

1. Verfahren zur Herstellung eines weitgehend phasenreinen, oxidischen Hochtemperatur-Supraleiters der allgemeinen Zusammensetzung SE-EA-Cu-O, wobei SE seltene Erdmetalle und EA Erdalkalimetalle sind, durch Sintern einer Mischung der Ausgangsoxide zur Herstellung eines Supraleiters mit Perowskitstruktur insbesondere von $Y_1Ba_2Cu_3O_{7-x}$, mit $x \leq 0,5$,
**dadurch gekennzeichnet,**
daß das Sintern unter erhöhten Drücken durch Einschluß der Ausgangsoxide in einem gasdichten Behälter (1) in einem chemisch und physikalisch abgeschlossenen System erfolgt,
- daß der oxidischen Ausgangsmischung (4) zur Erzeugung eines vorbestimmten Sauerstoffpartialdrucks wenigstens ein sich thermisch zersetzendes Metalloxid zugesetzt wird und
- daß die oxidische Ausgangsmischung (4) zur thermodynamischen Stabilisierung der gewünschten Supraleiterphase mit einer Schutzschicht (3) umhüllt wird, die in ihrer Zusammensetzung den jeweils koexistierenden Phasen des Supraleiters entspricht.

2. Verfahren nach Anspruch 1,
**dadurch gekennzeichnet,**
daß $BaO_2$ als sich thermisch zersetzendes Metalloxid zugesetzt wird.

3. Verfahren nach Anspruch 1 oder 2,
**dadurch gekennzeichnet,**
daß eine Drucksynthese der zuvor durch kaltisostatisches Pressen (CIP) verdichteten Ausgangsmischungen (4) durchgeführt wird (HIP).

4. Verfahren nach Anspruch 3,
**dadurch gekennzeichnet,**
daß eine auf die Drucksynthese folgende Abkühlung der Supraleiterphase unter Druck erfolgt.

5. Verfahren nach Anspruch 1 oder 2,
**dadurch gekennzeichnet,**
daß eine Drucksynthese der Supraleiterphase durch Sprengkompaktieren erfolgt, indem der Behälter (1) in Sprengstoff eingebettet und in einer druckfesten Explosionskammer gezündet wird.

6. Verfahren nach einem der Ansprüche 1 bis 5,
**dadurch gekennzeichnet,**
daß zur chemischen Abschirmung der oxidischen Ausgangsmischung (4) gegen das Material des Behälters (1) dieser mit einer Barriereschicht (2) ausgekleidet wird.

**Claims**

1. Method for producing an essentially phase-shift-free oxidic high-temperature superconductor of the general composition SE-EA-Cu-O, where SE stands for rare noble metals and EA for alkaline earth metals, by sintering a mixture of the basic oxides for superconductor fabrication with perovskite structure, in particular of $Y_1Ba_2Cu_3O_{7-x}$, where $x \leq 0.5$,
**characterised in that:**
sintering at elevated pressures is performed in a chemically and physically closed system by including the starting oxides in a gas-tight vessel (1),

- at least one thermally decomposing metal oxide is added to the basic oxidic mixture (4) to generate a predetermined oxygen partial pressure, and,
- to achive thermodynamic stabilisation of the desired supraconductor phase, the basic oxidic mixture (4) is covered by a protective layer (3) of the same composition as the respective co-existing phases of the superconductor.

2. Method as claimed in claim 1,
**wherein**
Ba O₂ is added as the thermally decomposing metal oxide.

3. Method as claimed in claim 1 or 2,
**wherein**
the basic mixtures (4) that have previously been compacted by cold isostatic pressing (CIP) are subjected to pressure synthesis (HIP).

4. Method as claimed in claim 3,
**wherein**
cooling of the superconducting phase after pressure synthesis is performed under pressure.

5. Method as claimed in claim 1 or 2,
**wherein**
pressure synthesis of the superconducting phase is effected via explosive compacting, by embedding the vessel (1) in an explosive which is ignited in a pressure-tight explosion chamber.

6. Method as claimed in one of claims 1 to 5,
**wherein**
the vessel (1) is lined on the inside with a barrier layer (2) in order to screen the basic oxidic mixture (4) chemically against the material of the vessel (1).

**Revendications**

1. Procédé pour la fabrication d'un supraconducteur à haute température, dans une large mesure exempt de déphasage, obtenu par voie d'oxydation de composition générale SE-EA-Cu-O, où SE sont des métaux terreux rares et EA des métaux alcalino-terreux, par frittage d'un mélange des oxydes de départ pour la réalisation d'un supraconducteur avec une structure de perovskite notamment de Y₁ Ba₂ Cu₃ O₇₋ₓ avec x ≦ 0,5,
procédé caractérisé en ce que :
- le frittage s'effectue sous des pressions élevées en enfermant les oxydes de départ dans un récipient étanche aux gaz (1) dans un système isolé chimiquement et physiquement,
- au moins un oxyde métallique se décomposant thermiquement est ajouté au mélange de départ (4) obtenu par voie d'oxydation pour engendrer une pression partielle d'oxygène prédéfinie,
- pour stabiliser thermodynamiquement la phase supraconductrice souhaitée, le mélange de départ (4) obtenu par voie d'oxydation est enveloppé par une couche de protection (3) dont la composition correspond aux phases respectivement co-existantes du supraconducteur.

2. Procédé selon la revendication 1, caractérisé en ce que BaO₂ est ajouté en tant qu'oxyde mé-tallique se décomposant thermiquement.

3. Procédé selon la revendication 1 ou la revendication 2, caractérisé en ce qu'une synthèse par pression des mélanges de départ (4) préalablement densifiés par pressage isostatique à froid (C.I.P) est effectuée ( HIP = compression isostatique à température élevée).

4. Procédé selon la revendication 3, caractérisé en ce qu'à la synthèse sous pression fait suite un refroidissement de la phase supraconductrice sous pression.

5. Procédé selon la revendication 1 ou la revendication 2, caractérisé en ce qu'une synthèse sous pression de la phase supraconductrice est effectuée par compactage par explosifs dans lequel le récipient (1) est enrobé dans l'explosif qui est amorcé dans une chambre d'explosion résistant à la pression.

6. Procédé selon une des revendications 1 à 5, caractérisé en ce que pour la protection chimique du mélange de départ (4) obtenu par voie d'oxydation, vis-à-vis du matériau du récipient (1), celui-ci est revêtu d'une couche-barrière (2).

Fig. 1

Fig. 2